# EUROPEAN PATENT APPLICATION

(11) **EP 1 437 930 A2**
(43) Date of publication of application: **14.07.2004**
(21) Application number: 03078888.9
(22) Date of filing: 08.12.2003
(51) Int. Cl.: H05K 5/06, H05K 9/00

(54) **Filtered electrical connector assembly for an overmolded electronic package**

(30) Priority: 07.01.2003 US 337649
(71) Applicant: Delphi Technologies, Inc., Troy, MI 48007 (US)
(72) Inventor: Brandenburg, Scott D., Kokomo, IN 46902 (US); Degenkolb, Thomas A., Noblesville, IN 46060 (US); Laudick, David A., Kokomo, IN 46901 (US)
(74) Representative: Denton, Michael John

(57) **Abstract**

An electronic package (50) and filtered electrical connector assembly (64) includes number of connector pins (80₁ - 80_{N}) extending away from a main circuit board (58) having a first ground plane (56), and an auxiliary circuit board (90) having a second ground plane (92) is positioned over board (58) with the connector pins (80₁ - 80_{N}) extending therethrough and electrically connected to a corresponding number of capacitors (94₁ - 94_{N}) mounted to board (90). An inductive block (82) and surrounding conductive spacer block (86) are positioned between boards (58) and (90) with the connector pins (80₁ - 80_{N}) extending through block (82) with block (86) electrically contacting the ground planes (56) and (92). A connector shroud (104) surrounds the connector pins (80₁ - 80_{N}) extending through board (90), and all components are bonded together via an overmolding process to form the electronic package (50).

## Description

### TECHNICAL FIELD

The present invention relates generally to packaging techniques for electronic circuits including one or more circuit-carrying circuit boards, and more specifically to such techniques incorporating therein a filtered electrical connector assembly.

### BACKGROUND OF THE INVENTION

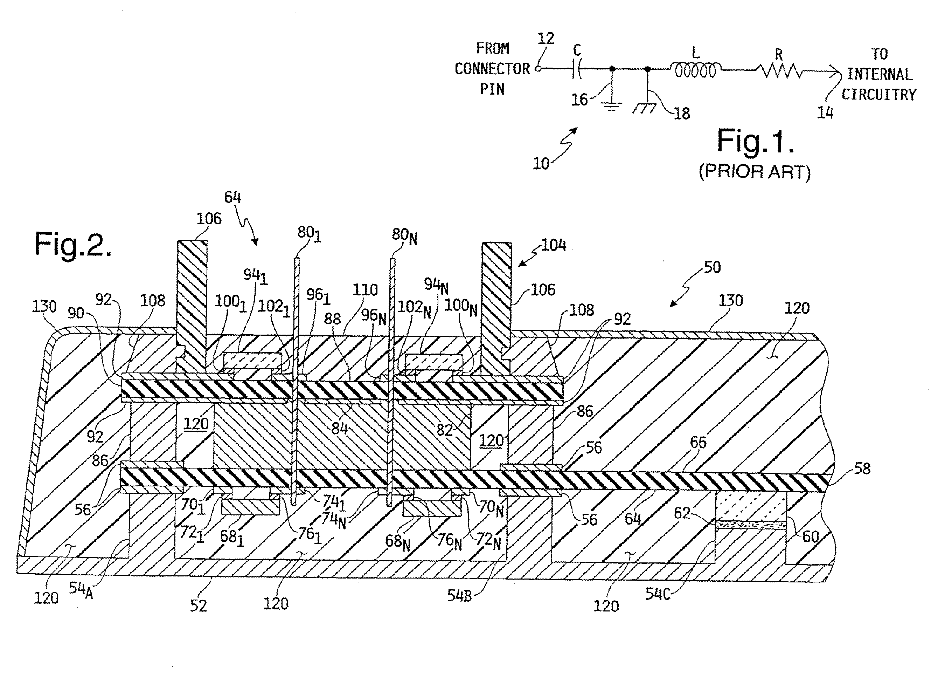

Electrical connectors for electronic packages or modules often include filtering circuitry for interfacing internal circuitry with external circuits and/or systems. Such filtering circuitry is typically designed to protect the internal circuitry from electromagnetic interference (EMI), radio frequency interference, (RFI), transients, overvoltage and/or other electrical conditions presented at the connector, as well as EMI radiated by the connector itself, and a popular example of one conventional filtering circuit 10 is illustrated in FIG. 1. Referring to FIG. 1, the illustrated connector filtering circuit 10 includes a capacitor, C, connected between a connector pin 12 and one end of an inductor, L, which is also connected to a circuit ground reference 16 and a chassis or system ground reference 18. The opposite end of the inductor, L, is connected to one end of a resistor, R, having an opposite end 14 connected to internal package circuitry. Typically, each pin comprising the electrical connector is connected to a separate, dedicated filtering circuit 10.

Packaging techniques have recently emerged wherein circuit-carrying printed circuit boards and/or rigid substrates are overmolded to form substantially rigid, and hermetically sealed packages or modules with the various package components bonded together via formable molding compound. Examples of such overmolded packaging techniques are disclosed in U.S. Patent No. 6,307,749 to Daanen et al., and also in U.S. Patent No. 6,285,551 and co-pending U.S. application Ser. No. 10/401,850, entitled OVERMOLDED ELECTRONIC PACKAGE INCLUDING CIRCUIT-CARRYING SUBSTRATE, both to Brandenburg et al., all of which are assigned to the assignee of the present invention and the disclosures of which are incorporated herein by reference.

Electronic package overmolding techniques, such as those described in the above-mentioned references, offer a number of advantages in terms of package and circuit reliability over previously known packaging techniques. It is accordingly desirable to provide for an electrical connector arrangement, including filtering circuitry of the type illustrated in FIG. 1, which may be incorporated into such an electronic package overmolding process.

### SUMMARY OF THE INVENTION

The present invention comprises one or more of the following features or combinations thereof. A filtered electrical connector assembly for an overmolded electronic package including a main circuit board defining a first ground plane thereon. The assembly may comprise a number of connector pins extending away from the main circuit board, an auxiliary circuit board having the number of connector pins extending therethrough with each of the connector pins electrically coupled to a second ground plane defined on the auxiliary circuit board via one of a corresponding number of capacitors mounted thereto, an inductive block positioned between the main circuit board and the auxiliary circuit board with the number of connector pins extending therethrough, a connector shroud positioned over the auxiliary circuit board and surrounding the number of connector pins, and means for electrically connecting the first and second ground planes. The inductive block may be a ferrite block. The means for electrically connecting the first and second ground planes may comprise at least one electrically conductive spacer block positioned adjacent to the inductive block between the main circuit board and the auxiliary circuit board, wherein the at least one electrically conductive spacer block electrically contacts each of the first and second ground planes. The means for electrically connecting the first and second ground planes may alternatively or additionally comprise a single electrically conductive spacer block surrounding the inductive block and electrically contacting the first and second ground planes.

The assembly may include a formable molding compound bonding together the main circuit board, the inductive block, the auxiliary circuit board, the connector shroud and the connecting means. The assembly may further include a backplate in contact with the main circuit board, wherein the backplate is bonded to the main circuit board via the formable molding compound.

The auxiliary circuit board may have a first surface facing the inductive block and a second opposite surface, wherein the second ground plane is defined on the first and second surfaces of the auxiliary circuit board. The connector shroud may include an electrically conductive member in contact with the second ground plane and exposed externally to the formable molding compound. The assembly may further include an electrically conductive film covering an outer surface of the electronic package and contacting the electrically conductive member of the connector shroud.

Each of the number of capacitors may be mounted to the second surface of the auxiliary circuit board and electrically connected between a corresponding one of the number of connector pins and the second ground plane. The second surface of the auxiliary circuit board may further define a number of conductive pads each surrounding and electrically contacting corresponding ones of the number of connector pins, wherein each of the number of capacitors is electrically connected between corresponding ones of the number of conductive pads and the second ground plane.

The assembly may further include a number of resistors mounted to the main circuit board and each electrically connected between corresponding ones of the connector pins and circuitry carried by the main circuit board. The main circuit board may have a first surface facing the inductive block and a second opposite surface having the number of connector pins extending therethrough, wherein the number of resistors are mounted to the second surface of the main circuit board.

The assembly may further include a protective medium contained within the connector shroud and covering the number of capacitors, wherein the number of connector pins extend outwardly away from the protective medium. The protective medium may comprise a formable medium dispensed into the connector shroud and thereafter set to form the protective medium covering the number of capacitors.

A method of forming a filtered electrical connector assembly for an overmolded electronic package including a main circuit board defining a first ground plane thereon may comprise the steps of mounting a number of connector pins to and through an auxiliary circuit board, mounting a corresponding number of capacitors to a first surface of the auxiliary circuit board with each of the capacitors electrically connected between a corresponding one of the number of connector pins and a second common ground plane formed on the first surface and also on a second opposite surface of the auxiliary circuit board, positioning an inductive block onto the number of connector pins extending from the second surface of the auxiliary circuit board with the number of connector pins extending through the inductive block, positioning an electrically conductive member about the inductive block, mounting the number of connector pins extending from the inductive block to and through the main circuit board with the electrically conductive member electrically contacting the first and second ground planes, positioning the main circuit board onto a backplate, positioning a connector shroud onto the first surface of the auxiliary circuit board with the connector shroud surrounding the number of chip capacitors and the number of connector pins extending from the first surface of the auxiliary circuit board, and bonding together the auxiliary circuit board, the connector shroud, the inductive block, the electrically conductive member, the main circuit board and the backplate via a formable molding compound to form the electronic package.

The connector shroud may further include an electrically conductive structure in contact with the second ground plane of the auxiliary circuit board and exposed externally to the molding compound, and the method may further include the step of forming an electrically conductive film over an outer surface of the electronic package in contact with the electrically conductive structure of the connector shroud. The step of forming the electrically conductive film may include contacting the electrically conductive film with the backplate.

The main circuit board may include a number of resistors mounted thereto, wherein each of the number of resistors are electrically connected between corresponding ones of the connector pins and circuitry carried by the main circuit board.

The connector shroud may define a cavity extending therein to the first surface of the auxiliary circuit board, and the method may further include the step of partially filling the cavity with a formable medium such that the formable medium covers the number of capacitors with the number of connector pins extending away from the formable medium.

These and other features of the present invention will become more apparent from the following description of the illustrative embodiments.

### BRIEF DESCRIPTION OF THE DRAWINGS

FIG. 1 is a schematic diagram of a conventional filtering circuit disposed between an electrical connector pin of an electronic module and circuitry contained within the module.
FIG. 2 is a cross-sectional view of an overmolded electronic package including a filtered electrical connector assembly carrying the conventional filtering circuitry illustrated in the schematic diagram of FIG. 1.
FIG. 3 is a plan view of one embodiment of the bottom surface of the auxiliary circuit board illustrated in FIG. 2.
FIG. 4 is a plan view of one embodiment of the top surface of the auxiliary circuit board illustrated in FIG. 2.
FIG. 5 is a flowchart illustrating one embodiment of a process for constructing an electronic package with the filtered electrical connector assembly of FIG. 2.

### DESCRIPTION OF THE ILLUSTRATIVE EMBODIMENTS

Referring now to FIG. 2, a cross-sectional view of an overmolded electronic package 50 is shown including a filtered electrical connector assembly 64 carrying the conventional filtering circuitry 10 illustrated in the schematic diagram of FIG. 1. Package 50 includes a backplate 52 having a circuit-carrying main printed circuit board 58 in contact therewith. Backplate 52 typically provides the dual functions of providing a ground plane or plate for the electronic package 50 and also providing a heat sink for one or more electrical components carried by the circuit board 58. The backplate 52 is accordingly an electrical and thermal conductor, and as such may be formed of a metal alloy including, for example, Aluminum and/or Copper, although those skilled in the art will appreciate that other electrically and thermally conductive materials and/or compositions may be used.

The printed circuit board 58 may be formed of conventional materials, and may take on any of a number of orientations relative to the backplate 52. In the illustrated embodiment, for example, the main circuit board 58 is mounted to the backplate 52 with a circuit-carrying surface 64 thereof facing the backplate 52. In such embodiments, the backplate 52 accordingly defines a number of posts or spacer blocks, e.g., 54A and 54B, separating the main circuit board 58 from the backplate (52) to provide clearance therebetween for circuitry carried by the main circuit board 58. Additionally, backplate 52 may define one or more heat sink blocks, e.g., 54C, that align with and contact a heat-generating electrical components, e.g., component 60, mounted to the main circuit board 58. In the illustrated embodiment, the electrical component 60 may be an integrated circuit, discrete electrical component or the like, and a known thermally conductive medium 62 may be disposed between the heat sink block 54C and the electrical component 60 to facilitate transfer of heat from the component 60 to the backplate 52. Examples of materials and/or substances that may be used as the thermally conductive medium include, but are not limited to, thermal grease, thermally conductive adhesive, thermally conductive epoxy or other formable medium, or the like. The main circuit board 58 may have any number of additional circuit components mounted to surface 64 to form one or more functional circuits. In one embodiment, the circuitry mounted to the main circuit board 58 comprises a control computer for controlling one or more structures and/or accessories carried by a motor vehicle. Examples of such structures and/or accessories include, but are not limited to, an internal combustion engine, a transmission, an entertainment system, a vehicle braking system, an active passenger restraint system, and/or the like.

The main circuit board 58 defines on each opposing surface thereof a ground plane 56, typically formed from an electrically conductive film patterned onto the circuit board 58. The ground plane 56 is patterned on the circuit-carrying surface 64 of the main circuit board 58 such that it aligns with, and therefore contacts, the posts or spacer blocks 54A and 54B defined by the backplate 52 when the main circuit board 58 is brought into operative contact with the backplate 52. In a typical application, the backplate 52 is electrically connected to chassis or system ground, and by connecting the backplate 52 to the ground plane 56 of the main circuit board 58 as just described, the chassis or system ground and circuit grounds are connected together as indicated by ground elements 16 and 18 in FIG. 1. The main circuit board 58 further defines a number, N, of holes therethrough sized to receive therein a corresponding number of connector pins 80₁ - 80_{N}, wherein N may be any positive integer. The number of connector pins 80₁ - 80_{N} are mechanically affixed to the main circuit board 58 and electrically connected to a corresponding number of electrical leads 74₁ - 74_{N} formed on the circuit-carrying surface 64 of the main circuit board 58 between the posts or spacer blocks 54A and 54B. The electrical leads 74₁ - 74_{N} are typically formed from the electrically conductive film patterned onto the circuit board 58. Mechanical and electrical attachment of the number of connector pins 80₁ - 80_{N} to the circuit board 58 and corresponding electrical leads 74₁ - 74_{N} may be accomplished via any known means including, for example, known solder reflow techniques.

Each of the number of electrical leads 74₁ - 74_{N} is mechanically and electrically connected to one end of one of a corresponding number of resistors 68₁ - 68_{N} via a suitable attachment medium 76₁ - 76_{N}, and the opposite ends of the resistors 68₁ - 68_{N} are each mechanically and electrically connected to a corresponding number of electrical leads 70₁ - 70_{N} via a suitable attachment medium. As with the electrical leads 74₁ - 74_{N}, the electrical leads 70₁ - 70_{N} are formed from electrically conductive film patterned onto the circuit board 58, and the electrical leads 70₁ - 70_{N} are routed to other circuitry, e.g., component 60, carried by the main circuit board 58. The attachment media 72₁ - 72_{N} and 76₁ - 76_{N} may each be any known mechanical/electrical attachment medium including, for example, reflowable solder. The number of resistors 68₁ - 68_{N} correspond to the resistor, R, illustrated in FIG. 1 for each of the number of connector pins 80₁ - 80_{N}.

In the illustrated embodiment, the ground plane 56 is patterned on surface 66 of the main circuit board 58 opposite surface 64 such that it aligns with the posts or spacer blocks 54A and 54B defined by the backplate 52 when the main circuit board 58 is brought into operative contact with the backplate 52. It is to be understood that such alignment is not strictly required, and is shown as such in FIG. 2 only for the purpose of depicting one illustrative embodiment of the electronic package 50 and filtered electrical connector 64. It is desirable in some embodiments of the electronic package 50 and filtered electrical connector 64 for the ground plane 56 formed on surface 66 of the main circuit board 58 completely surround the connector pins 80₁ - 80_{N}, as will be described in greater detail hereinafter.

An inductive block 82 defines a number of holes therethrough (not shown) that align with corresponding ones of the connector pins 80₁ - 80_{N}, and connector pins 80₁ - 80_{N} are received through each of these holes so that block 84 comes into contact with, and rest against, the surface 66 of the main circuit board with the connector pins 80₁ - 80_{N} extending therethrough. The inductive block 82 may be formed of any known inductive material, and in one embodiment block 82 is a ferrite block. In any case, the inductive block forms the inductor, L, for each connector pin filtering circuit as illustrated in FIG. 1.

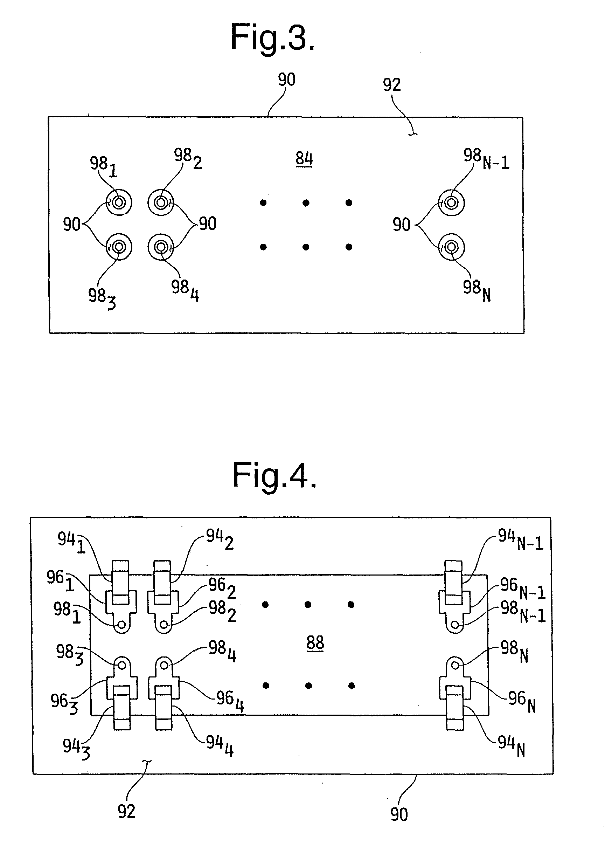

An auxiliary circuit board 90 may be formed of conventional circuit board materials and defines therethrough a number of holes 98₁ - 98_{N} (e.g., see FIGS. 3 and 4) that align with corresponding ones of the number of connector pins 80₁ - 80_{N} extending through the inductive block 82. The connector pins 80₁ - 80_{N} are received through the corresponding holes 98₁ - 98_{N} defined through the auxiliary circuit board 90 so that the bottom surface 84 of the circuit board 90 comes into contact with, and rests against, the ferrite block 82 with the connector pins 80₁ - 80_{N} extending through an opposite top surface 88 of the auxiliary circuit board 90.

Referring now to FIG. 3 a plan view of one illustrative embodiment of the bottom surface 84 of the auxiliary circuit board 90 is shown. In the illustrated embodiment, the auxiliary circuit board 90 defines a ground plane 92 over almost the entire bottom surface 84, leaving only a small area of exposed circuit board 90 about each of the holes 98₁ - 98_{N} to prevent shorting of the connector pins 80₁ - 80_{N} to the ground plane 92. This configuration of the ground plane 92 is intended to ensure an adequate ground connection to the inductive block in contact therewith to satisfy the circuit requirement illustrated in FIG. 1. Those skilled in the art will recognize that alternative ground plane patterns may be substituted for the ground plane pattern 92 illustrated in FIG. 3 without detracting from the scope of the present invention, as long as an adequate ground reference connection is made to the inductive block 82.

Referring now to FIG. 4, a plan view of one illustrative embodiment of the top surface 88 of the auxiliary circuit board 90 is shown. The top surface 88 of the auxiliary circuit board 90 defines thereon more of the ground plane 92 defined on the bottom surface 84 thereof. Those skilled in the art will recognize that the two ground planes may be electrically connected by plating through any number of holes (not shown) defined between the ground planes formed on the two opposing surfaces 84 and 88. In the illustrated embodiment, the auxiliary circuit board 90 defines the ground plane 92 such that it surrounds the holes 98₁ - 98_{N} defined therethrough for purposes that will be described more fully hereinafter. In any case, the auxiliary circuit board 90 further defines on the top surface 88 thereof a number, N, of electrically conductive pads 96₁ - 96_{N} each formed about a corresponding one of the holes 98₁ - 98_{N} defined through the auxiliary circuit board. The pads 96₁ - 96_{N} and holes 98₁ - 98_{N} are all configured such that electrical connection may easily be made to each of the corresponding connector pins 80₁ - 80_{N} using conventional techniques, e.g., reflowable solder or the like. The electrically conductive pads 96₁ - 96_{N} are sized to provide for the mechanical and electrical attachment thereto of first ends of a corresponding number of chip capacitors 94₁ - 94_{N} as illustrated in FIG. 4. The opposite second ends of capacitors 94₁ - 94_{N} are mechanically and electrically attached to the ground plane 92, and the number of capacitors 94₁ - 94_{N} correspond to the capacitor, C, illustrated in FIG. 1 for each of the number of connector pins 80₁ - 80_{N}. Each of the capacitors 94₁ - 94_{N} may be mechanically and electrically attached to the corresponding conductive pads 96₁ - 96_{N} and to the ground plane 92 via any known means therefor, e.g., reflowable solder.

Referring again to FIG. 2, means 86 are provided for electrically connecting the ground plane 92 defined on the auxiliary circuit board 90 to the ground plane 56 defined by the main circuit board 58 to thereby satisfy the circuit 16 and chassis or system 18 ground connection to the capacitor-inductor junction as illustrated in FIG. 1. In one embodiment at least one electrically conductive spacer block 86 is positioned between, and in contact with, the ground plane 92 formed on the auxiliary circuit board 90 and the ground plane 56 formed on the main circuit board 58 to thereby electrically connect the two ground planes. In the illustrated embodiment, the spacer block 86 defines a passageway therethrough that is sized slightly larger than the inductive block 82. In this embodiment, the spacer block 86 thus defines four unitary walls forming a ground reference enclosure surrounding the inductive block 82. Alternatively, the spacer block 86 may be formed of one or more individual electrically conductive spacer elements connecting the ground plane 92 to the ground plane 56. Alternatively still, one or more of the outer edges of the auxiliary circuit board 90 may be bent or otherwise formed downwardly such that ground plane 92 comes into contact with ground plane 56. Electrical connection therebetween may be enhanced in this case via a suitable attachment mechanism, e.g., reflowable solder. In another alternative embodiment, one or more wires, posts, or other electrically conductive structures may be disposed between and suitably attached between the ground planes 92 and 56 to form an electrical connection therebetween.

A connector shroud 104 includes an electrically non-conductive sleeve 106 attached to an electrically conductive member 108 and positioned in contact with the top surface 88 of the auxiliary circuit board 90 such that the sleeve 106 and conductive member 108 surround the conductive pins 80₁ - 80_{N} and capacitors 94₁ - 94_{N} with the electrically conductive member 108 in contact with the ground plane 92. The sleeve 106 may be formed of a suitable electrically non-conductive material, such as any of a number of plastic materials, and may be attached to the electrically conductive member 108 via any suitable means such as via injection molding, adhesive, or the like. In any case, the connector shroud 104 is configured for suitable connection to a mating electrical connector (not shown).

The components various components of the electronic package 50 and filtered electrical connector assembly 64 described thus far are arranged in contact with each other as described, and the entire subassembly is then overmolded with a suitable formable molding compound 120 using known techniques therefore to form the overmolded electronic package 50. The formable molding compound may be a conventional electronic package molding compound, or may alternatively be a proprietary compound developed for the particular application. In either case, the molding compound 120 is configured to come into contact with, and fill the spaces around, each of the backplate 52, main circuit board 58, inductive block 82, conductive spacer block 86, auxiliary circuit board 90 and connector shroud 104, and to thereafter cure to a set state to rigidly bond together each of these components and form a substantially rigid electric package 50 that houses the main circuit board 58 and the filtered electrical connector assembly 64.

Another formable medium 110 is dispensed onto the surface 88 of the auxiliary circuit board 90 and confined thereto by the connector shroud 104. Medium 110 is electrically non-conductive and is supplied in sufficient quantity to cover the capacitors 94₁ - 94_{N} attached to the top surface 88 of the auxiliary circuit board 90. The medium 110 is thereafter cured to a set state, and forms a substantially impervious barrier between the external environment and the combination circuit board 90 and capacitors 94₁ - 94_{N}. Medium 110 may be any conventional electrically non-conductive medium known in the electrical connector art such as, for example, a formable epoxy, silicone potting compound, plastic resin, or the like.

The electrically conductive member 108 may be left exposed external to the package 50 during the overmolding process, as illustrated in FIG. 2, and a conductive film 130 may then be disposed over the package 50 in electrical contact with member 108, and optionally with the backplate 52, to form a ground plane that completely envelops the package 50. The film 130 may be a formable film that is sprayed or otherwise deposited onto the package 50, or may alternatively be a conductive sheet that is affixed to the outer surface of package 50.

In the illustrated embodiment, as described hereinabove, the ground plane 92 is formed about the entire periphery of the top surface 88 of the auxiliary circuit board 90, and the electrically conductive spacer block 86 comprises a unitary wall structure completely surrounding the inductive block 82. With the electrically conductive member 108 of the connector shroud 104, spacer block 86 and spacer blocks 54A and 54B all aligned with each other as shown in FIG. 2, these structures form a nearly continuous ground enclosure about the filtered electrical connector assembly 64 from the top surface of the package 50 to the backplate 52. This illustrative structure serves to ensure adequate ground connections and enhance suppression of electromagnetic interference between assembly 64 and the circuitry carried by the main circuit board 58.

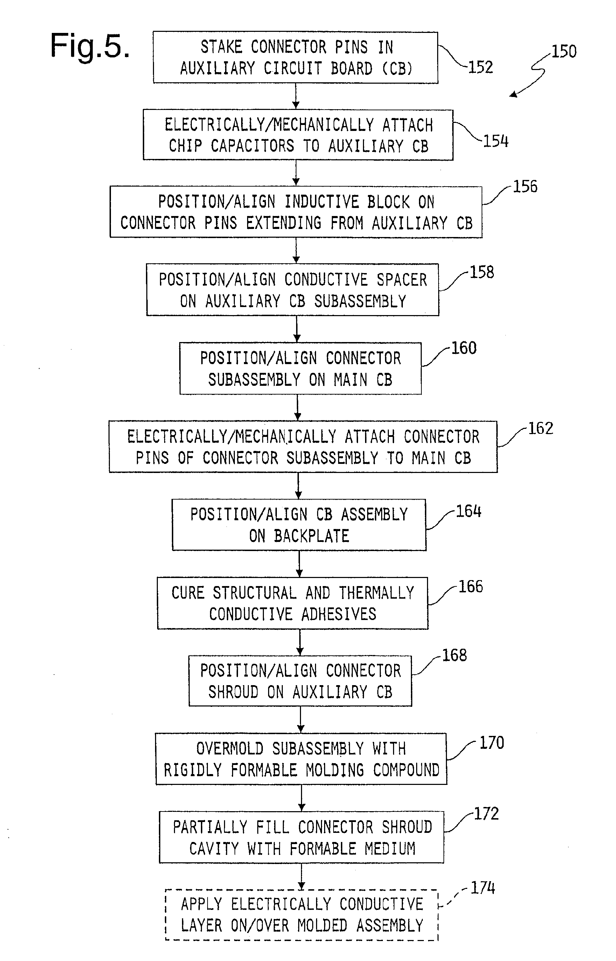

Referring now to FIG. 5, a flowchart is shown illustrating one embodiment of a process 150 for constructing an electronic package 50 with the filtered electrical connector assembly 64 of FIG. 2. Process 150 begins at step 152 where the connector pins 80₁ - 80_{N} are staked in the auxiliary circuit board 90 by electrically and mechanically attaching each of the pins 80₁ - 80_{N} to the auxiliary circuit board 90 as described hereinabove. Thereafter at step 154, the chip capacitors 94₁ - 94_{N} are mechanically mounted to the auxiliary circuit board (90) and electrically connected between the various connector pins 80₁ - 80_{N} and the ground plane (92) as described hereinabove. Those skilled in the art will recognize that steps 152 and 154 may alternatively be reversed in sequence.

In any case, process 150 advances from step 154 to step 156 where the inductive (e.g., ferrite) block 82 is aligned with and positioned onto the connector pins 80₁ - 80_{N} such that block 82 is positioned adjacent to the bottom surface 84 of the auxiliary circuit board 90 as illustrated in FIG. 2. Thereafter at step 158, the conductive spacer block 86 is aligned with and positioned about the inductive block 82 in contact with the main circuit board 58 about the inductive block 82 as illustrated in FIG. 2. Following step 158, process 150 advances to step 160 where the subassembly comprising the auxiliary circuit board 90, connector pins 80₁ - 80_{N}, inductive block 82 and conductive spacer block 86 is aligned with and positioned on the main circuit board 58 with the connector pins 80₁ - 80_{N} extending through the main circuit board 58. Thereafter at step 162, the connector pins 80₁ - 80_{N} are electrically and mechanically attached to the main circuit board 58 via known means, e.g., solder reflow. Step 162 presumes that the resistors 68₁ - 68_{N} are already mounted to the circuit board 58.

Following step 162, process 150 advances to step 164 where the circuit board assembly comprising the auxiliary circuit board 90, connector pins 80₁ - 80_{N}, inductive block 82, conductive spacer block 86 and main circuit board 58 is aligned with and positioned on the backplate 52. Thereafter at step 166, the thermally conductive adhesive 62 and any structural adhesives joining the main circuit board 58 to the backplate 52 are cured. Following step 166, the connector shroud 104 is aligned with and positioned onto the auxiliary circuit board 90 such that it surrounds the connector pins 80₁ - 80_{N} and chip capacitors 94₁ - 94_{N} mounted to the auxiliary circuit board 90, and forms a cavity extending to the top surface 88 of the auxiliary circuit board 90.

Following step 168, process 150 advances to step 170 where the entire subassembly comprising the auxiliary circuit board 90, connector pins 80₁ - 80_{N}, inductive block 82, conductive spacer block 86, main circuit board 58, backplate 52 and connector shroud 104 is then bonded together via an overmolding process at step 64, as illustrated and described with respect to FIG. 2. It bears pointing out that while one or more adhesives may be used to bond the backplate 52 to the main circuit board 58, and/or to provide a thermally conductive medium between the backplate 52 and one or more heat-generating circuits; e.g., circuit 60, mounted to the main circuit board 58 as illustrated in FIG. 2, the connector subassembly 64 constructed in accordance with steps 152-168 otherwise requires no adhesives or other fixation materials. Rather, only point contacts are made in the subassembly of the filtered electrical conenctor 64 between the backplate 52, main circuit board 58, inductive block 82, conductive spacer block 86, auxiliary circuit board 90 and connector shroud 104.

Following step 170, process 150 advances to step 172 where the cavity defined by the connector shroud 104 and the auxiliary circuit board 90 is filled with the formable medium 110, which is thereafter cured, such that the formable medium 110 covers the chip capacitors 94₁ - 94_{N} with the connector pins 80₁ - 80_{N} extending therefrom as illustrated in FIG. 2. Optionally, as illustrated in FIG. 2 and by the dashed-line box 174 following step 172, process 150 may include the step of forming an electrically conductive layer 120 on and over the molded assembly 50 in electrical contact with at least the electrically conductive member 108 of the connector shroud 104, and optionally still with the backplate 52.

While the invention has been illustrated and described in detail in the foregoing drawings and description, the same is to be considered as illustrative and not restrictive in character, it being understood that only illustrative embodiments thereof have been shown and described and that all changes and modifications that come within the spirit of the invention are desired to be protected. For example, while the embodiment illustrated in FIG. 2 depicts the main circuit board 58 mounted to the backplate 52 with the circuit-carrying surface 64 facing the backplate 52, it will be understood that the backplate 52 and main circuit board 58 may be alternatively configured such that the opposite surface 66 of the circuit board 58 contacts the backplate 52. In such embodiments, the backplate 52 may be affixed via suitable means to the circuit board 58 either before or after the overmolding process. As another example, it is contemplated that the resistors 68₁ - 68₂ may alternatively be mounted to the opposite side 66 of the main circuit board 58, and/or that the capacitors 94₁ - 94₂ may alternatively be mounted to the opposite side 84 of the auxiliary circuit board 90, adjacent to the inductive block 82.

## Claims

1. A filtered electrical connector assembly (64) for an overmolded electronic package (50) including a main circuit board (58) defining a first ground plane (56) thereon, the assembly comprising:
a number of connector pins (80₁ - 80_{N}) extending away from said main circuit board (58);
an auxiliary circuit board (90) having said number of connector pins (80₁ - 80_{N}) extending therethrough with each of said connector pins (80₁ - 80_{N}) electrically coupled to a second ground plane (92) defined on said auxiliary circuit board (58) via one of a corresponding number of capacitors (94₁ - 94_{N}) mounted thereto;
an inductive block (82) positioned between said main circuit board (58) and said auxiliary circuit board (90) with said number of connector pins (80₁ - 80_{N}) extending therethrough;
a connector shroud (104) positioned over said auxiliary circuit board (90) and surrounding said number of connector pins (80₁ - 80_{N}); and
means (86) for electrically connecting said first (56) and second (92) ground planes.

2. The assembly of claim 1 further including a formable molding compound (120) bonding together said main circuit board (58), said inductive block (86), said auxiliary circuit board (90), said connector shroud (104) and said connecting means (86).

3. The assembly of claim 2 wherein said main circuit board (58) has a first surface (66) facing said inductive block (82) and a second opposite surface (64);
and further including a backplate (52) in contact with said second surface (64) of said main circuit board (58), said backplate (52) bonded to said main circuit board (58) via said formable molding compound (120).

4. The assembly of claim 2 wherein said auxiliary circuit board (90) has a first surface (84) facing said inductive block (86) and a second opposite surface (88), said second ground (92) plane being defined on said second surface (88) of said auxiliary circuit board (90);
and wherein said connector shroud (104) includes an electrically conductive member (108) in contact with said second ground plane (92) and exposed externally to said formable molding compound (120).

5. The assembly of claim 4 further including an electrically conductive film (130) covering an outer surface of the electronic package (50) and contacting said electrically conductive member (108) of said connector shroud (104).

6. The assembly of claim 1 wherein said auxiliary circuit board (90) has a first surface (84) facing said inductive block (82) and a second opposite surface (88) with said second ground plane (92) defined thereon;
and wherein each of said number of capacitors (94₁ - 94_{N}) is mounted to said second surface (88) of said auxiliary circuit board (90) and electrically connected between a corresponding one of said number of connector pins (80₁ - 80_{N}) and said second ground plane (92).

7. The assembly of claim 1 wherein said main circuit board (58) has a first surface (66) facing said inductive block (82) with said first ground plane (56) defined thereon and said auxiliary circuit board (90) has a first surface (84) facing said inductive block (86) with said second ground plane (92) defined thereon;
and wherein said means for electrically connecting said first (56) and second (92) ground planes comprises at least one electrically conductive spacer block (86) positioned adjacent to said inductive block (82) between said main circuit board (58) and said auxiliary circuit board (90), said at least one electrically conductive spacer block (86) electrically contacting each of said first (56) and second (92) ground planes.

8. The assembly of claim 7 wherein said at least one electrically conductive spacer block (86) surrounds said inductive block (82).

9. The assembly of claim 1 wherein said auxiliary circuit board (90) has a first surface (84) facing said inductive block (82) and a second opposite surface (88), said second ground plane (92) being defined on said first surface (84) of said auxiliary circuit board (90) and also about a periphery of said second surface (88) thereof;
and wherein said second surface (88) of said auxiliary circuit board (90) further defines a number of conductive pads (96₁ - 96_{N}) each surrounding and electrically contacting corresponding ones of said number of connector pins (80₁ - 80_{N});
and wherein each of said number of capacitors (94₁ - 94_{N}) is electrically connected between corresponding ones of said number of conductive pads (96₁ - 96_{N}) and said second ground plane (92).

10. The assembly of claim 1 further including a number of resistors (68₁ - 68_{N}) mounted to said main circuit board (58) and each electrically connected between corresponding ones of said connector pins (80₁ - 80_{N}) and circuitry carried by said main circuit board (58).

11. The assembly of claim 10 wherein said main circuit board (58) has a first surface (66) facing said inductive block (82) and a second opposite surface (64) having said number of connector pins (80₁ - 80_{N}) extending therethrough;
and wherein said number of resistors (68₁ - 68_{N}) are mounted to said second surface (64) of said main circuit board (58).

12. The assembly of claim 1 wherein said auxiliary surface board (90) has a first surface (84) facing said inductive block (82) and a second opposite surface (88) having said number of capacitors (94₁ - 94_{N}) mounted thereto and said connector shroud (104) positioned thereon;
and further including a protective medium (110) contained within said connector shroud (104) and covering said number of capacitors (94₁ - 94_{N}), said number of connector pins (80₁ - 80_{N}) extending outwardly away from said protective medium (110).

13. The assembly of claim 12 wherein said protective medium (110) comprises a formable medium dispensed into said connector shroud (104) and thereafter set to form said protective medium (110) covering said number of capacitors (94₁ - 94_{N}).

14. The assembly of claim 1 wherein said inductive block (82) is a ferrite block.

15. A filtered electrical connector assembly (64) for an overmolded electronic package (50) including a main circuit board (58) defining a first ground plane (56) thereon, the assembly comprising:
a number of connector pins (80₁ - 80_{N}) extending away from said main circuit board (58);
an auxiliary circuit board (90) having a first surface (84) facing said main circuit board (58) and a second opposite surface (88), said number of connector pins (80₁ - 80_{N}) extending through said auxiliary circuit board (90), and each of said first (84) and second (88) surfaces of said auxiliary circuit board (90) defining thereon a common second ground plane (92) surrounding said number of connector pins (80₁ - 80_{N});
an inductive block (82) positioned between said main circuit board (58) and said auxiliary circuit board (90) with said number of connector pins (80₁ - 80_{N}) extending therethrough;
a number of capacitors (94₁ - 94_{N}) mounted to said second surface (88) of said auxiliary circuit board (90), each of said number of capacitors (94₁ - 94_{N}) electrically connected between a corresponding one of said number of connector pins (80₁ - 80_{N}) and said second ground plane (92);
a spacer block (86) positioned between said main (58) and auxiliary (90) circuit boards defining at least one electrically conductive wall positioned adjacent to said inductive block (82) and electrically contacting said first (56) and second (92) ground planes; and
a connector shroud (104) in contact with said second surface (88) of said auxiliary circuit board (90) and surrounding said number of connector pins (80₁ - 80_{N}).

16. The assembly of claim 15 further including a formable molding compound (120) bonding together said main circuit board (58), said inductive block (82), said auxiliary circuit board (90), said spacer block (86) and said connector shroud (104).

17. The assembly of claim 15 wherein said main circuit board (58) has a first surface (66) facing said inductive block (82) and a second opposite surface (64), each of said first (66) and second (64) surfaces of said main circuit board (58) defining said first ground plane (56) thereon;
and further including an electrically conductive backplate (52) electrically contacting said first ground plane (56) formed on said second surface (64) of said main circuit board (58).

18. The assembly of claim 17 further including a formable molding compound (120) bonding together said backplate (52), said main circuit board (58), said inductive block (82), said auxiliary circuit board (90), said spacer block (86) and said connector shroud (104).

19. The assembly of claim 18 wherein said connector shroud (104) includes an electrically conductive member (108) having a first surface in contact with said second ground plane (92) formed on said second surface (88) of said auxiliary circuit board (90) and a second surface exposed externally to said formable molding compound (120);
and further including an electrically conductive film (130) covering an outer surface of the electronic package (50) and contacting said electrically conductive member (108) of said connector shroud (104) and said backplate (52).

20. The assembly of claim 19 further including a protective medium (110) contained within said connector shroud (104) and covering said number of capacitors (94₁ - 94_{N}), said number of connector pins (80₁ - 80_{N}) extending outwardly away from said protective medium (110).

21. The assembly of claim 20 wherein said protective medium (110) comprises a formable medium dispensed into said connector shroud (104) and thereafter set to form said protective medium covering said number of capacitors (94₁ - 94_{N}).

22. The assembly of claim 20 wherein said number of connector pins (80₁ - 80_{N}) extend through said main circuit board (58) beyond said second surface (64) thereof;
and further including a number of resistors (68₁ - 68_{N}) mounted to said second surface (64) of said main circuit board (58), each of said number of resistors (68₁ - 68_{N}) electrically connected between a corresponding one of said connector pins (80₁ - 80_{N}) and circuitry carried by said main circuit board (58).

23. The assembly of claim 15 wherein said inductive block (82) is a ferrite block.

24. A method of forming a filtered electrical connector assembly (64) for an overmolded electronic package (50) including a main circuit board (58) defining a first ground plane (56) thereon, the method comprising the steps of:
mounting a number of connector pins (80₁ - 80_{N}) to and through an auxiliary circuit board (90);
mounting a corresponding number of capacitors (94₁ - 94_{N}) to a first surface (88) of said auxiliary circuit board (90) with each of said capacitors (94₁ - 94_{N}) electrically connected between a corresponding one of said number of connector pins (80₁ - 80_{N}) and a second common ground plane (92) formed on said first surface (88) and also on a second opposite surface (84) of said auxiliary circuit board (90);
positioning an inductive block (82) onto said number of connector pins (80₁ - 80_{N}) extending from said second surface (84) of said auxiliary circuit board (90) with said number of connector pins (80₁ - 80_{N}) extending through said inductive block (82);
positioning an electrically conductive member (86) about said inductive block (82);
mounting said number of connector pins (80₁ - 80_{N}) extending from said inductive block (82) to and through said main circuit board (58) with said electrically conductive member (86) electrically contacting said first (56) and second (92) ground planes;
positioning said main circuit board (58) onto a backplate (52);
positioning a connector shroud (104) onto said first surface (88) of said auxiliary circuit board (90) with said connector shroud (104) surrounding said number of chip capacitors (94₁ - 94_{N}) and said number of connector pins (80₁ - 80_{N}) extending from said first surface (88) of said auxiliary circuit board (90); and
bonding together said auxiliary circuit board (90), said connector shroud (104), said inductive block (82), said electrically conductive member (86), said main circuit board (58) and said backplate (52) via a formable molding compound (120) to form the electronic package (50).

25. The method of claim 24 wherein said connector shroud (104) further includes an electrically conductive structure (108) in contact with said second ground plane (92) of said auxiliary circuit board (90) and exposed externally to said molding compound (120);
and further including the step of forming an electrically conductive film (130) over an outer surface of the electronic package (50) in contact with said electrically conductive structure (108) of said connector shroud (104).

26. The method of claim 25 wherein the step of forming said electrically conductive film (130) includes contacting said electrically conductive film (130) with said backplate (52).

27. The method of claim 26 wherein said main circuit board (58) includes a number of resistors (68₁ - 68_{N}) mounted to said main circuit board (58), each of said number of resistors (68₁ - 68_{N}) electrically connected between corresponding ones of said connector pins (80₁ - 80_{N}) and circuitry carried by said main circuit board (58).

28. The method of claim 24 wherein said connector shroud (104) defines a cavity extending therein to said first surface (88) of said auxiliary circuit board (90);
and further including the step of partially filling said cavity with a formable medium (110) such that said formable medium (110) covers said number of capacitors (94₁ - 94_{N}) with said number of connector pins (80₁ - 80_{N}) extending away from said formable medium (110).
